# EUROPEAN PATENT SPECIFICATION

(11) **EP 3 147 881 B1**
(45) Date of publication and mention of the grant of the patent: **13.11.2019**
(21) Application number: 16192671.2
(22) Date of filing: 13.03.2014
(51) Int. Cl.: G08C 17/02, G07C 5/00

(54) **VEHICLE MEASUREMENT APPARATUS HAVING A SYSTEM-ON-A-CHIP DEVICE, A SENSOR AND A WIRELESS ADAPTER**
FAHRZEUGMESSVORRICHTUNG MIT EINER SYSTEM-ON-CHIP-VORRICHTUNG, EINEM SENSOR UND DRAHTLOSEN ADAPTER
APPAREIL DE MESURE DE VÉHICULE COMPORTANT UN DISPOSITIF DE SYSTÈME SUR UNE PUCE, UN CAPTEUR ET UN ADAPTATEUR SANS FIL

(30) Priority: 13.03.2013 US 201313801346; 13.03.2013 US 201313801794
(43) Date of publication of application: 29.03.2017
(62) Divisional of application: 14773908.0
(73) Proprietor: Bosch Automotive Service Solutions Inc., Warren, Michigan 48092 (US); Robert Bosch GmbH, 70442 Stuttgart (DE)
(72) Inventor: CHINNADURAI, Manokar, Owatonna, MN 55060 (US); LE BRUN, Marco, 50129 Firenze (IT); MARTINI, Mario, 43123 Parma (IT)
(74) Representative: Isarpatent

(56) References cited:
- US-A1- 2004 227 523
- US-A1- 2007 032 098
- US-A1- 2008 071 440
- US-A1- 2011 251 807
- US-B1- 6 941 114

## Description

### FIELD OF THE DISCLOSURE

The present disclosure relates generally to diagnostic equipment and method. More particularly, the present disclosure relates to a vehicle measurement apparatus having a system-on-a-chip device, a sensor and a wireless adapter.

### BACKGROUND OF THE DISCLOSURE

A conventional vehicle measurement apparatus (e.g., an oscilloscope) includes a Field Programmable Gate Array (FPGA) separated from a microprocessor unit (MCU) by a galvanic isolation. The galvanic isolation separating the FPGA and the MCU reduces the interference between an analog section of the measurement apparatus, which receives external signals under test, and a digital section that communicates with an external computing device.

Unfortunately, such an arrangement increases component cost and size of the measurement apparatus, and has higher power consumption. Further, such a conventional measurement apparatus is inflexible in its design. A need exists to increase the flexibility of conventional measurement apparatus.

A conventional measurement device (e.g., a vehicle oscilloscope or a multimeter), especially one that does not have built-in wireless capability, requires a wired connection to a personal computer (PC) for controlling the measurement device and displaying various waveforms and measured values. A typical use of the conventional measurement device is to locate problems in a vehicle, following a troubleshooting tree or procedure. In most cases, the conventional measurement device has to be connected to circuits or components under the hood of the vehicle, while the PC and the operator stay in the driver's seat.

Unfortunately, having such a wired connection of conventional measurement device to an external computer is unwieldy and not flexible (e.g., in the above-noted use scenario). In addition, the conventional measurement device has to be separately powered, which also adds to the unwieldiness of the conventional measurement device during measurements. These and other problems, which have been identified by the inventors, exist in conventional systems. Thus there is a need for a wireless adapter for a measurement device.

US 2008/071440 A1 discloses a system of power management for a vehicle communication interface.

### SUMMARY OF THE INVENTION

The present invention provides a wireless adapter for a measurement device according to claim 1 and method for wirelessly transmitting vehicle data according to claim 9.

### BRIEF DESCRIPTION OF THE DRAWINGS

FIG. 1 is a schematic block diagram illustrating a conventional vehicle measurement apparatus.
FIG. 2 is a schematic diagram illustrating a vehicle measurement apparatus, in accordance with an embodiment of the disclosure.
FIG. 3 is a flowchart for a method for measuring vehicle data, in accordance with an embodiment of the disclosure.
FIG. 4 is a schematic block diagram of a wireless adapter system, in accordance with an embodiment of the disclosure.
FIG. 5 is a method for wirelessly transmitting machine data, in accordance with an embodiment of the disclosure.

### DETAILED DESCRIPTION

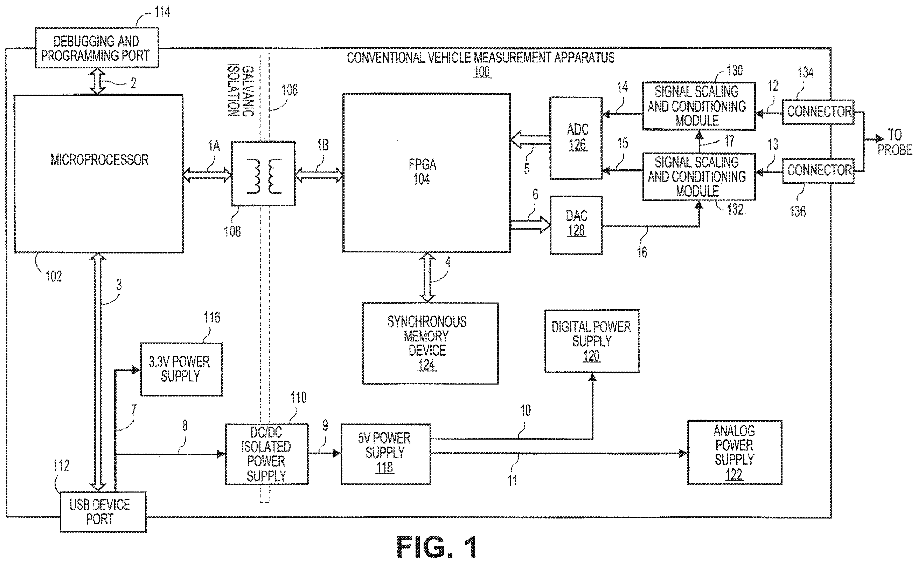

Referring to FIG. 1, a schematic block diagram of a conventional vehicle measurement apparatus 100 is illustrated. Conventional vehicle measurement apparatus 100 includes a microprocessor 102 in electrical communication with a field programmable gate array (FPGA) 104. Microprocessor 102 is separated from FPGA 104 by a galvanic isolation 106. Galvanic isolation 106 is coupled to a transformer 108, which couples microprocessor 102 with FPGA 104 electrically. Microprocessor 102 is coupled to transformer 108 by a connection 1A, and to FPGA 104 by a connection 1B. One side of galvanic isolation 106 that includes FPGA 104 and other components forms an analog portion of conventional vehicle measurement apparatus 100. Another side of galvanic isolation 106 that includes microprocessor 102 forms a digital portion of conventional vehicle measurement apparatus 100.

The digital portion of conventional vehicle measurement apparatus 100 may include a debugging and programming port 114 coupled to microprocessor 102 by a connection 2. Microprocessor 102 is coupled to a universal serial bus (USB) port 112 by a connection 3. USB port 112 is coupled to a 3.3V power supply 116 by a connection 7, and to a direct current-to-direct current (DC/DC) isolated power supply 110 by a connection 8. Conventional vehicle measurement apparatus 100 may include other electrical or electronic components in the digital portion, in addition to the components described above. Additionally, some components, for example, transformer 108 and DC/DC isolated power supply 110 may be shared between the digital and the analog portions of conventional vehicle measurement apparatus 100, as illustrated in FIG. 1.

The analog portion of conventional vehicle measurement apparatus 100 may include a 5V power supply 118 coupled to DC/DC isolated power supply 110 by a connection 9. 5V power supply 118 may in turn be coupled to a digital power supply 120 by a connection 10, and to an analog power supply 122 by a connection 11. Connectors 134 and 136 are connected to an external probe (not shown). Connectors 134 and 136 are also coupled to signal scaling and conditioning modules 130 and 132, respectively, by connections 12 and 13, respectively. Connections 12 and 13 carry analog data received from the probe that is placed on one or more parts of a machine under test (not shown). Such a machine may be a vehicle (e.g., a car), or any other machine that is to be tested. For example, a vehicle engine may be tested for parameters such as vibrations, emissions, engine speed, acceleration, or other parameters, using the probe that is placed on a portion of the vehicle engine. The probe then provides analog signals to connectors 134 and 136 corresponding to the parameter(s) under consideration. Signal scaling and conditioning modules 130 and 132 are coupled to each other by a connection 17. Signal scaling and conditioning modules 130 and 132 are both coupled to an analog to digital converter (ADC) 126 by connections 14 and 15, respectively. ADC 126 is coupled to FPGA 104 by a connection 5 and FPGA 104 is coupled to a digital to analog converter (DAC) 128 by a connection 6, which is in turn coupled to signal scaling and conditioning module 132 by a connection 16. FPGA 104 may be coupled to a synchronous memory device 124 by a connection 4.

However, conventional vehicle measurement apparatus 100 suffers from many drawbacks and problems. For example, galvanic isolation 106 used to reduce interference between the analog and digital components of conventional vehicle measurement apparatus 100 increases the bulkiness or weight of conventional vehicle measurement apparatus 100. As a result, the size of conventional vehicle measurement apparatus 100 increases or is not optimum. Presence of transformer 108 leads to transformer losses, and also adds to the weight of conventional vehicle measurement apparatus 100. In addition, DC/DC isolated power supply 110 also increases the number of components of conventional vehicle measurement apparatus 100 as well as the complexity of circuitry inside. DC/DC isolated power supply 110 does not fully eliminate dangerous current loops that might leak into a ground path of conventional vehicle measurement apparatus 100. Further, the increased number of components is related to the problem of inability to add more components, such as sensors, internally to conventional vehicle measurement apparatus 100. In this respect, the design of conventional vehicle measurement apparatus 100 is hard to modify, and is therefore, inflexible. Furthermore, communication between microprocessor 102 and FPGA 104 is hindered by limited bandwidth of connections 1A and 1B. Generally, conventional vehicle measurement apparatus 100 has circuit boards whose dimensions are quite large and are not optimized.

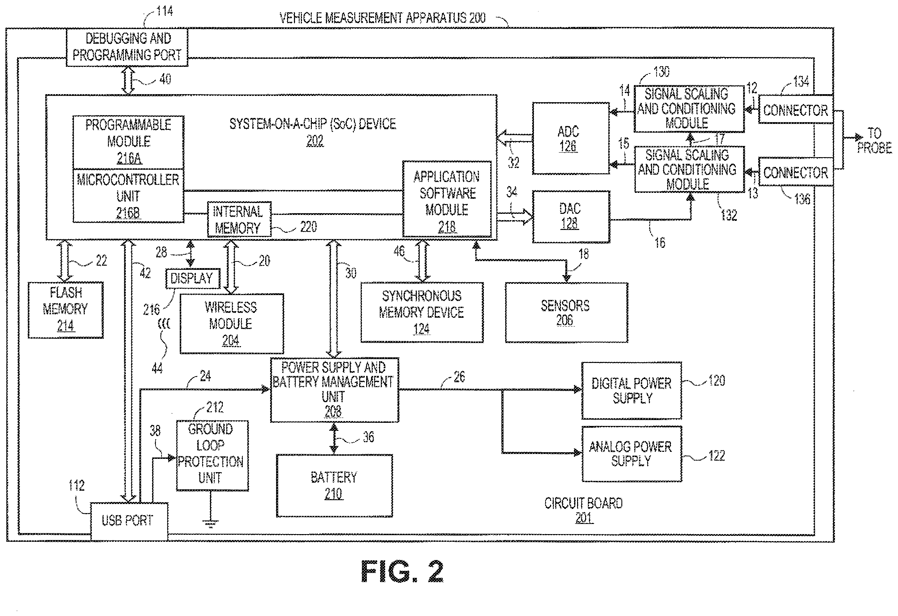

Referring to FIG. 2, a schematic diagram of a vehicle measurement apparatus 200 is illustrated, in accordance with an embodiment of the present disclosure. In FIG. 2, reference numerals for drawing elements common with FIG. 1 remain same. The term "vehicle" relates to a machine, for example, an automobile, a truck, ship, airplane, a turbine, a generator, etc., or to a part thereof (e.g., an engine). Vehicle measurement apparatus 200 may be an oscilloscope, a wireless oscilloscope, a vehicle oscilloscope, an automotive oscilloscope, a multi-meter, a vehicle multi-meter, a wireless multi-meter, an automotive multi-meter, or other types of electronic, electrical, or electromechanical measurement apparatii for measuring and analyzing machine parameters. In one embodiment, vehicle measurement apparatus 200 is arranged to be couplable to a part of the machine (e.g., a vehicle). For example, vehicle measurement apparatus 200 is couplable to an engine part of an automobile under a hood of the automobile. One or more measurements may be taken using vehicle measurement apparatus 200. In one embodiment, vehicle measurement apparatus 200 may have a hard outside cover for environmental protection, or for operation in harsh or hazardous environment. For example, vehicle measurement apparatus 200 may be used in a high temperature environment, a toxic gas environment, or other environments harmful to vehicle measurement apparatus 200. In one embodiment, vehicle measurement apparatus 200 is light weight and small sized to reach otherwise inaccessible parts of machines. Further, as discussed herein, vehicle measurement apparatus 200 is adapted to communicate with an external computing device (e.g., a remote computer, not shown). Such communication may be wireless, wired, or both. For example, vehicle measurement apparatus 200 may communicate with a computer located away from where vehicle measurement apparatus 200 is coupled to the machine. For example, such a computer may be located inside a passenger compartment area of a vehicle. Likewise, vehicle measurement apparatus 200 may communicate with more than one external computing device simultaneously. For example, measurements obtained by vehicle measurement apparatus 200 may be transmitted to a personal computer, a mobile phone, a tablet computer, etc. In one embodiment, vehicle measurement apparatus 200 may receive one or more instructions from such an external computing device, such as updates to software or operating system of vehicle measurement apparatus 200. In one embodiment, vehicle measurement apparatus 200 is a mobile or portable device (e.g., a handheld device). Alternatively, vehicle measurement apparatus 200 may not be a mobile device. For example, vehicle measurement apparatus 200 may be fixed to a part of a machine as a monitoring device for testing the machine in use. In one embodiment, a body of vehicle measurement apparatus 200 may have one or more ports, power switches, antennas, power inlets, a security lock, one or more slits for fluid flow, etc. In one embodiment, vehicle measurement apparatus 200 may have a receptacle or a recess to couple external battery pack or other adapters (e.g., a wireless adapter).

In one embodiment, vehicle measurement apparatus 200 includes a circuit board 201, such as a printed circuit board (PCB). Circuit board 201 includes a system-on-a-chip (SoC) device 202 (interchangeably referred to herein as a programmable SoC device 202), a wireless module 204 coupled to SoC device 202 by a connection 20, a sensor(s) 206 coupled to SoC device 202 by a connection 18, a display 216 coupled to SoC device 202 by a connection 28, a power supply and battery management unit 208 coupled to SoC device 202 by a connection 30, and a flash memory 214 coupled to SoC device 202 by a connection 22. In one embodiment, circuit board 201 includes ADC 126 and DAC 128 coupled to SoC device 202 by connections 32 and 34, respectively. In one embodiment, circuit board 201 includes a battery 210 coupled to power supply and battery management unit 208 by a connection 36. In one embodiment, circuit board 201 includes a ground loop protection unit 212 coupled to USB port 112 by a connection 38. In one embodiment, power supply and battery management unit 208 is coupled to USB port 112 by a connection 24 at an input terminal (not shown), and to digital power supply 120 and analog power supply 122 at an output terminal (not shown) by connection 26. In one embodiment, circuit board 201 includes other components similar to those in conventional vehicle measurement apparatus 100 such as connectors 134 and 136, signal scaling and conditioning modules 130 and 132, and debugging and programming port 114. For example, debugging and programming port 114 is coupled to SoC device 202 by a connection 40. Further, circuit board 201 may include additional components such has heat sinks, electrostatic protection circuits, etc., known to those having ordinary skill in the art. It is to be noted that the connections in FIG. 2 similar to those discussed with respect to FIG. 1 are not being discussed again herein. In one embodiment, vehicle measurement apparatus 200 may include one or more other circuit boards, different and physically separated from circuit board 201, although such circuit boards may be electrically coupled to circuit board 201.

In another embodiment, SoC device 202 is a programmable SoC device. In one embodiment, SoC device 202 is an integrated chip (IC) hard wired to circuit board 201. A packaging of SoC device 202 protects it from external electromagnetic fields. Additionally, such packaging protects internal circuitry of SoC device 202 from interference between analog and digital signals in vehicle measurement apparatus 200. By way of example only and not by way of limitation, SoC device 202 may be a ZYNQ-7000® series of all-purpose programmable SoC devices provided by Xilinx Inc. of San Jose, CA programmed to implement features and functionalities of the one or more embodiments discussed herein.

In a further embodiment, SoC device 202 includes a programmable module 216a integrated with a microcontroller unit 216b, an internal memory 220, and an application software module 218. SoC device 202 is programmable via debugging and programming port 114. Since, programmable module 216a and microcontroller unit 216b are integrated with each other in SoC device 202, a high bandwidth communication occurs between programmable module 216a and microcontroller unit 216b. The term "integrated" relates to programmable module 216a and microcontroller unit 216b being integrated in SoC device 202 or having functionalities within a single chip, which in this embodiment is SoC device 202. For example, programmable module 216a and microcontroller unit 216b are integrated on a common substrate of SoC device 202. In this example, programmable module 216a and microcontroller unit 216b may not be separate discrete hardware elements inside SoC device 202. Instead, programmable module 216a and microcontroller unit 216b may be implemented on the same hardware area of SoC device 202 (e.g., using same programmable logic circuitry). Such integration of programmable module 216a and microcontroller unit 216b advantageously removes the requirement of galvanic isolation 106, as found in conventional vehicle measurement apparatus 100. Since there is no galvanic isolation 106 and/or transformer 108 in vehicle measurement apparatus 200, vehicle measurement apparatus 200 can be smaller and lighter with fewer components than conventional vehicle measurement apparatus 100. Further, such integration ameliorates the problem of interference between analog and digital portions of vehicle measurement apparatus 200.

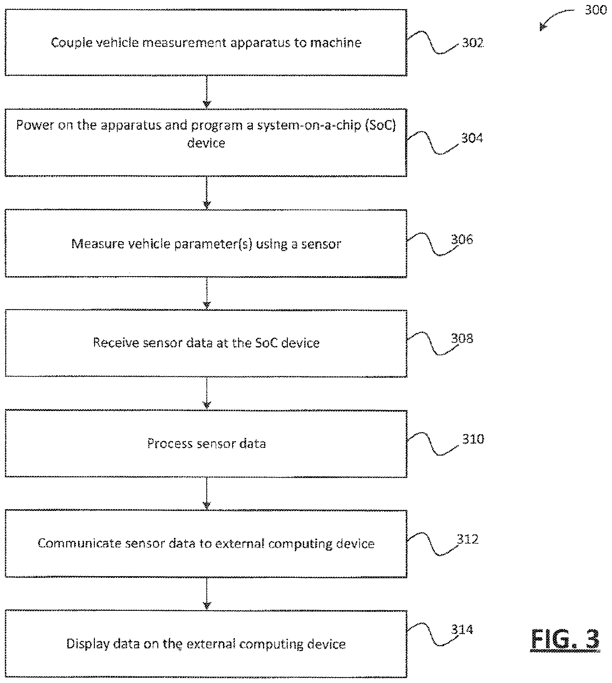

In one embodiment, SoC device 202 may be programmed to implement functionalities of both FPGA 104 and microprocessor 102. For example, FPGA 104 may be implemented by programming programmable module 216a, and microprocessor 102 may be implemented using microcontroller unit 216b. Alternatively or additionally, programmable module 216a may be configured as a programmable logic controller or an application specific circuit in SoC device 202. In one embodiment, programmable module 216a receives vehicle data (e.g., automotive data) from sensor 206, and may perform digital signal processing (DSP) operations on such received data. Alternatively or additionally, programmable module 216a may receive vehicle data from ADC 126, and may be sent to microcontroller unit 216b for processing. Additionally, SoC device 202 may transmit digital data to DAC 128 over connection 34 to further scale and/or condition the received vehicle data at signal scaling and conditioning module 132. Programming of SoC device 202 to implement programmable module 216a and microcontroller unit 216b (or, functionalities of programmable module 216a and microcontroller unit 216b) is discussed with respect to FIG. 3.

In one embodiment, application software module 218 may be a set of instructions that are executed by microcontroller unit 216b to process vehicle data. As discussed herein, such vehicle data is associated with one or more parameters of a machine, or a part thereof, under test. Such vehicle data may be obtained initially as analog signals using a probe (not shown) connected to circuit board 201 at connectors 134 and 136. After scaling and conditioning by signal scaling and conditioning modules 130 and 132, and conversion to digital data by ADC 126, SoC device 202 can use application software module 218 to analyze the vehicle data. The set of instructions that comprise application software module 218 may reside on internal memory 220.

In another embodiment, internal memory 220 may a tangible non-transitory memory that is used by programmable module 216a and microcontroller unit 216b. For example, internal memory 220 may be a type of random access memory (RAM), although other types of on-chip memory implementations may be used.

SoC device 202 may include other components such as clock circuitry, interrupt handling routines, central interconnect logic, input-output (IO) interfaces, memory access controllers, wireless communication controller(s), wired communication controller(s), look-up tables (LUTs), signal and voltage management circuitry, etc. For example, SoC device 202 interfaces with other components of circuit board (e.g., sensor 206) via output pins. Such output pins of SoC device 202 may be hard wired to trace routes of circuit board 201, as known to one of ordinary skill in the art.

In one embodiment, SoC device 202 can be configured to communicate processed vehicle data to an external computing device (not shown). In this respect, the term "external" relates to any device outside vehicle measurement device 200. Such communication may occur over wired or wireless channels. For example, SoC device 202 may communicate vehicle data processed by microcontroller unit 216b to USB port 112 over a connection 42. A computer connected externally at USB port 112 though a wired connection (e.g., a USB cable) may then display such processed vehicle data. Likewise, SoC device 202 may communicate the processed vehicle data to wireless module 204 over connection 20. Wireless module 204 may then wirelessly transmit the processed vehicle data to the external computing device through a wireless transmission 44.

In one embodiment, connectors 134 and 136 receive vehicle data in an analog form (e.g., as analog signals). Such data corresponds to one or more parameters of a machine under test. For example, such parameters, collected at a probe (not shown), are measurements corresponding to vibration or acceleration of a machine part. Other examples of parameters may include measurements related to rotation speed of an engine (e.g., in rotations per minute), emissions from an exhaust of an engine, engine temperature, or other parameters of machine testing known to those of ordinary skill in the art. By way of example only, connectors 134 and 136 that receive such vehicle data may be Bayonet Neill-Concelman (BNC) type connectors, although other types of connectors known to one of ordinary skill in the art may be used.

In one embodiment, data received by connectors 134 and 136 is scaled and conditioned by signal scaling and conditioning modules 130 and 132. Received vehicle data may be sent over separate channels to signal scaling and conditioning modules 130 and 132 such that each of signal scaling and conditioning modules 130 and 132 forms a separate channel for analog vehicle data received as analog signals by connectors 134 and 136, respectively. In one embodiment, received vehicle data may not need signal scaling and/or conditioning. Circuit details of signal scaling and conditioning modules 130 and 132 are known to those of ordinary skill in the art, and will not be described herein.

In one embodiment, received vehicle data, after scaling and/or conditioning, may be converted to digital format by ADC 126. By way of example only, ADC 126 may be a 12-bit, 40Msps, two channel type ADC. An output of ADC 126 is coupled to SoC device 202 by connection 32.

Likewise, DAC 128 may receive an 8-bit output from SoC device 202. Such digital output from SoC device 202 may be converted to analog signals for further scaling and conditioning by signal scaling and conditioning modules 130 and 132, for example.

In one embodiment, circuit board 201 includes sensor 206, which may share space on circuit board 201 with SoC device 202. In this respect, circuit board 201 is a common circuit board for SoC device 202 and sensor 206. Sensor 206 can be coupled to and in direct communication with SoC device 202. Such a direct communication and coupling is implemented using, for example, a trace on circuit board 201, shown as connection 18. In one embodiment, sensor 206 may be either stacked over/under SoC device 202. In one embodiment, sensor 206 and SoC device 202 may be fabricated from a same substrate and disposed in a common housing. Sensor 206 measures vehicle data associated with a parameter (e.g., vibration) of a part of a machine (e.g., an automobile engine). In one embodiment, sensor 206 is a vibration sensor, which can measure vibration of a machine or a part thereof to which vehicle measurement apparatus 200 is coupled. In one embodiment, sensor 206 is an acceleration sensor, which can measure acceleration of a machine or a part thereof to which vehicle measurement apparatus 200 is coupled. Likewise sensor 206 may be used to measure other machine parameters known to ordinary skill in the art, for example but not limited to detecting acoustic, pressure, vibration, accelerometer, motion, or any signals. In one embodiment, sensor 206 is a micro-electromechanical system (MEMS) sensor. Depending on the parameter being measured, sensor 206 may be a MEMS vibration sensor or a MEMS acceleration sensor, or other type of MEMS sensor. An example advantage of circuit board 201 having sensor 206 hardwired thereto is that a user of vehicle measurement apparatus 200 can get more accurate readings for processing by SoC device 202 due to close physical proximity of sensor 206 to SoC device 202. Sensor 206 hardwired to circuit board 201 also results in a more compact design of vehicle measurement apparatus 200. In one embodiment, sensor 206 may be in an IC package.

In one embodiment, power supply and battery management unit 208 can be configured to control power supplied to SoC device 202 over connection 30. Power supply and battery management unit 208 forms a common control point for digital power supply 120, analog power supply 122, and battery 210. In one embodiment, power supply and battery management unit 208 may receive instructions to intelligently manage power distribution in circuit board 201 from an external computing device via USB port 112. For example, of power supply and battery management unit 208 may include one or more switches to electronically toggle between power from an external computing device, battery 210, digital power supply 120, and analog power supply 122.

In one embodiment, digital power supply 120 may provide power to digital components of circuit board 201, including power to SoC device 202. Digital power supply 120 may be, for example, a 3.3V or a 1.2V power supply. Likewise, analog power supply 122 provides power to analog components of circuit board 201. For example, analog power supply 122 may provide power, such as 3V, a 5V, or a -5V, to signal scaling and conditioning modules 130 and 132. In one embodiment, either one of or both digital power supply 120 and analog power supply 122 may be operable to provide different voltage levels.

In one embodiment, battery 210 is chargeable through USB port 112 over connection 36 via connection 24. For example, battery 210 is chargeable at a rate of up to 1.5A through USB port 112, in accordance with "USB Battery Charging 1.2 Compliance plan" by USB Implementers Forum Inc., dated October 12, 2011. In one embodiment, battery 210 supplies power to SoC device 202. For example, when vehicle measurement apparatus 200 is used as a mobile or portable device, or when mains supply power is not available, battery 210 provides power to SoC device 202 as well as to other components of circuit board 201. Battery 210 may be a Lithium ion, Lithium Oxygen, Lithium air, or air cell battery, although other types of batteries known to one of ordinary skill in the art may be used.

In one embodiment, wireless module 204 includes circuitry and antenna to implement wireless communication with an external computing device (not shown). By way of example only, wireless module 204 may be a Bluetooth wireless communication protocol device, NFC (Near Field Communication), a WiFi™ wireless communication protocol device, or other wireless communication protocol device based on IEEE 802.11 standard known to one of ordinary skill in the art. An advantage of using the Bluetooth protocol is that it is simpler to implement and has lower power requirements as compared to WiFi® protocol. However, as known to one of ordinary skill in the art, WiFi® protocol is more secure. In one embodiment, wireless module 204 may be optional. Incorporating wireless module 204 advantageously removes the need for galvanic isolation 106 of conventional vehicle measurement apparatus 100. This results in a simplified power supply design for vehicle measurement apparatus 200.

In one embodiment, display 216 may be a light emitting diode (LED) 7-segment display, although other types of displays known to one of ordinary skill in the art could be used such as a touch-screen display, an organic LED (OLED) display, etc. Display 216 may indicate various status indicators for SoC device 202. Display 216 may obtain such status messages over connection 28. For example, the status messages may read, for example, "POWER ON", "POWER OFF", "IDLE", "BUSY", or other types of status messages known to one of ordinary skill in the art. In one embodiment, display 216 may be optional.

In one embodiment, synchronous memory device 124 may be a random access memory (RAM). Synchronous memory device 124 may supplement internal memory 220 if a memory capacity of internal memory 220 is not sufficient to carry out functioning of SoC device 202. By way of example only, synchronous memory device may be a 1.152MB synchronous static RAM. In one embodiment, synchronous memory device 124 may be optional, for example, when SoC device 202 has sufficient internal memory 220.

Likewise, in one embodiment, flash memory 214 may be a temporary buffer type memory. SoC device 202 during course of operation may store temporary results or variables in flash memory 214. Similar to synchronous memory device 124, flash memory 214 may be optional. By way of example only, flash memory 214 may be a NAND or a NOR type flash memory known to one of ordinary skill in the art.

In one embodiment, vehicle measurement apparatus 200 includes a ground loop protection unit 212 coupled to USB port 112 by connection 38, although other types of ports, including coaxial cable type ports, may be used. For example, when vehicle measurement apparatus 200 is used with a wired connection via USB port 112, galvanic isolation 106 in conventional vehicle measurement apparatus 100 is replaced with ground loop protection unit 212 that protects vehicle measurement apparatus 200, the external computing system, and circuits external to circuit board 201 from destructive currents due to shorts through a ground path of vehicle measurement apparatus 200. Such protection is attained by ground loop protection unit 212 preventing or safely grounding one or more current loops that may leak to non-ground traces of circuit board 201 and cause damage to vehicle measurement apparatus 200.

In one embodiment, connections 18, 20, 22, 24 26, 28, 30, 32, 34, 36, 38, 40, 42, and 46 are traces on circuit board 201. Bi-directional arrows (single-lined or double) are used to indicate full-duplex communications or signal flows. Unidirectional arrows indicate simplex communications or signal flows. It is to be noted that circuit board 201 may have other additional connections, not shown, depending on additional components placed thereupon.

Referring to FIG. 3, a method 300 for measuring vehicle data using vehicle measurement apparatus 200 is illustrated as a flowchart. It is to be noted that although the operations shown in flowchart of method 300 are in increasing order, such operations are not restricted to any particular order. For example, the operations can be carried out independently, may be combined as a single operation, or may be optional under certain conditions, as will be apparent to one of ordinary skill in the art in view of the present disclosure.

In one embodiment, method 300 may begin an operation 302 where vehicle measurement apparatus 200 is coupled to a machine (e.g., an automobile) or a part thereof (e.g., under a car's hood). Such coupling of vehicle measurement apparatus 200 may be performed by a human user, or by a robot, or other type of machine. Coupling of vehicle measurement apparatus 200 may be carried out simply by placing vehicle measurement apparatus 200 on a part of the machine. For example, in certain scenarios, due to the advantageously small size of vehicle measurement apparatus 200, placement thereof may occur is small spaces between parts of an engine of a machine. Alternatively, coupling may be carried out using mechanical tools such as screws, clamps, latches, or other tools known to one of ordinary skill in the art. In one embodiment, vehicle measurement apparatus 200 itself may not be coupled directly to the machine. Instead, a probe connected to one or more connectors of vehicle measurement apparatus 200 (e.g., connectors 134 and 136) may be used to measure vehicle data associated with the machine or a part thereof. For example, the probe may be coupled to a vibrating or accelerating machine part to measure a vibration or acceleration thereof, respectively.

In one embodiment, in an operation 304, vehicle measurement apparatus 200 may be powered on. Such powering on may be carried out by flipping a switch on an outside surface of the body of vehicle measurement apparatus 200. Alternatively, vehicle measurement apparatus 200 may be powered on using a remote control operated by a user. Upon power on of vehicle measurement apparatus 200, SoC device 202 may be programmed. Programming SoC device 202 is carried out via debugging and programming port 114 coupled to circuit board 201, as illustrated in FIG. 2 for example. For example, programming SoC device 202 may be carried out from an external graphical user interface on an external computing device. For example, instructions on internal memory 220 may be executed to run application software module 218 in conjunction with the user interface of a programming language used to program SoC device 202. Programming SoC device 202, for example, using application software module 218, implements programmable module 216a and microcontroller unit 216b on a single IC chip, which is SoC device 202. For example, application software module 218 may be executed by on on-chip processor core (not shown) of SoC device 202. In this respect, using on-chip hardware of SoC device 202, such as memory areas of internal memory 220, the functionality of FPGA 104 and microprocessor 102 of conventional vehicle measurement apparatus 100 may be integrated on a single device, which is SoC device 202. In one embodiment, SoC device 202 may be hardware programmable as well as software programmable. For example, programming SoC device 202 may include initiation of one or more state variables that are used to enumerate one or more parameters of the machine measured by vehicle measurement apparatus 200. In one embodiment, Universal Markup Language (UML) or C programming language may be used to program SoC device 202.

In one embodiment, in an operation 306, vehicle measurement apparatus 200 measures one or more machine parameters. As discussed herein, such parameters may include vibration data, acceleration data, engine speed data, emission data, or other types of vehicle data known to those of ordinary skill in the art. Such measurements of vehicle data may be carried out via a probe attached to vehicle measurement apparatus 200, e.g., at connectors 134 and 136. Alternatively, in one embodiment such measurements may be carried out by sensor 206 on circuit board 201 of vehicle measurement apparatus 200. In one embodiment, multiple parameters of a machine may be measured using both the probe connected at connectors 134 and 134 as well as sensor 206.

In one embodiment, in an operation 308, SoC device 202 receives the measured vehicle data. In one embodiment, SoC device 202 may receive vehicle data from connectors 134 and 136. Connectors 134 and 134 output analog signals associated with the measured vehicle data. These analog signals are then scaled and/or conditioned by signal scaling and conditioning modules 130 and 132. Such scaling and conditioning of analog signals is known to one of ordinary skill in the art, and will not be described herein. One or more output channels of signal scaling and conditioning modules 130 and 132 provide the scaled and/or conditioned analog signals to ADC 126. ADC 126 converts the analog signals to digital signals that are provided to SoC device 202. For example, the received vehicle data in digital form is provided by ADC 126 to programmable module 216a of SoC device 202. In one embodiment, SoC device 202 may receive the measured vehicle data from sensor 206. SoC device 202 may receive the measured vehicle data from sensor 206 as a digital signal or an analog signal over connection 18. For example, sensor 206 may provide the received vehicle data in digital form to programmable module 216a of SoC device 202, when programmable module 216a is programmed as an FPGA. When sensor 206 outputs analog signals corresponding to the measured vehicle data, internal ADCs (not shown) of SoC device 202 may convert the received analog signals from sensor 206 to equivalent digital signals for processing. In this respect, SoC device 202 is programmed to receive both analog as well as digital signals. The ability of SoC device 202 in vehicle measurement apparatus 200 to handle both analog and digital signals makes SoC device 202 a mixed signal device.

In one embodiment, in an operation 310, SoC device 202 processes the received vehicle data. For example, such processing may begin at an internal ADC of SOC device 202 that converts a received analog signal to a digital format. When the received vehicle data is already in a digital format (e.g., received from ADC 126), such processing may include microcontroller unit 216b breaking the received digital data into bytes for processing. Additionally, such processing may involve performing digital signal processing (DSP) functions on the received vehicle data (e.g., for spectrum analysis), vibration analysis, advanced triggering and analysis of vehicle communication busses such as Controller Area Network (CAN) and FlexRay, analysis of vehicle battery ripple to extract information such as engine revolutions per minute (rpm), analysis of alternators' waveforms for test purposes, or other types of signal analyses that may be performed using programmable module 216a and microcontroller unit 216b of SoC device 202.

In one embodiment, in an operation 312, the processed vehicle data is communicated to an external computing device (e.g., a personal computer (PC)). Such communicating may occur wirelessly or over a wired channel. For example, SoC device 202 may communicate the processed vehicle data to wireless module 204 over connection 20. Wireless module 204 may initiate wireless transmission 44 to the external computing device. By way of example only, such communicating may be over a Bluetooth protocol or a WiFi® protocol. Alternatively, such communicating may occur through USB port 112 coupled to SoC device 202 by connection 42. In this example, a PC or other computing device may be connected to USB port 112's output to receive the processed vehicle data.

In one embodiment, in an operation 314, the processed vehicle data may be displayed on a display (not shown) of an external computing device. For example, a person sitting in a driver's seat of a car may be able to view vehicle data on a PC outside the hood of the car. Such displayed data may then be analyzed or presented in a format that allows a machine tester to learn about one or more parameters or performance of the machine.

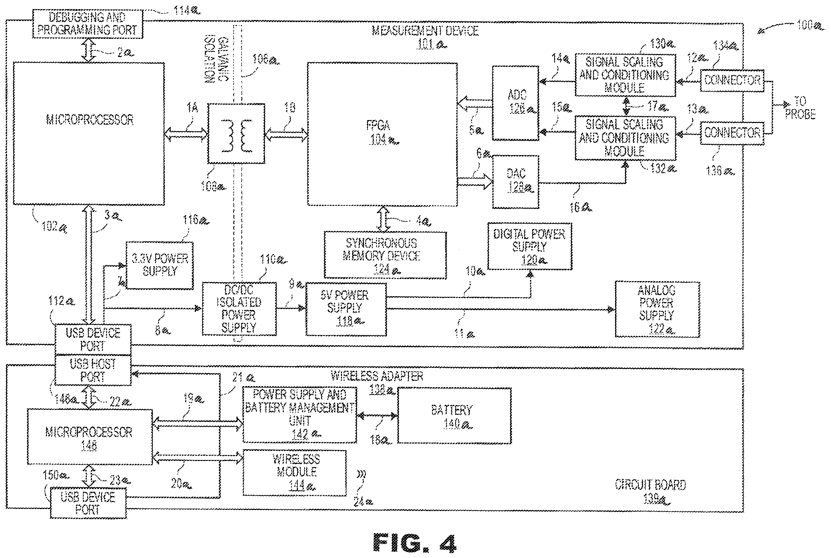

Referring to FIG. 4, a schematic block diagram of a wireless adapter system 100a is illustrated, in accordance with an embodiment of the present disclosure. Wireless adapter system 100a includes a measurement device 101a and a wireless adapter 138a. Measurement device 101a and wireless adapter 138a may be coupled to each other.

Measurement device 101a may be interchangeably referred to herein as measurement apparatus 101a. In one embodiment, measurement device 101a may be a scan tool, an oscilloscope, an electronic multi-meter, or other types of devices used for measuring data associated with a machine (e.g., a vehicle). Measurement device 101a includes a microprocessor 102a in electrical communication with a field programmable gate array (FPGA) 104a. Microprocessor 102a may be separated from FPGA 104a by a galvanic isolation 106a. Galvanic isolation 106a may be connected to or coupled to a transformer 108a (interchangeably referred to herein as an optical or magnetic coupler 108a), which couples microprocessor 102a with FPGA 104a electrically. Microprocessor 102a can be connected to transformer 108a by a connection 1Aa, and to FPGA 104a by a connection 1Ba. A side of galvanic isolation 106a that includes FPGA 104a and other components forms a mixed-signal portion of measurement device 101a having analog and digital components. Another side of galvanic isolation 106a that includes microprocessor 102a forms a digital portion of measurement device 101a.

The digital portion of measurement device 101a may include a debugging and programming port 114a coupled to microprocessor 102a by a connection 2a. Microprocessor 102a can be coupled to a universal serial bus (USB) port 112a by a connection 3a. USB port 112a may be coupled to a 3.3V power supply 116a by a connection 7a, and to a direct current-to-direct current (DC/DC) isolated power supply 110a by a connection 8a. Measurement device 101a may include other electrical or electronic components in the digital portion, in addition to the components described above. In one embodiment, USB port 112a can couple to other external USB ports or cables, and may be used to couple other devices to measurement device 101a.

The mixed-signal portion of measurement device 101a may include a 5V power supply 118a coupled to DC/DC isolated power supply 110a by a connection 9. 5V power supply 118a may further be coupled to a digital power supply 120a by a connection 10a, and to an analog power supply 122a by a connection 11a. Connectors 134a and 136a may be connected to an external probe (not shown). Connectors 134a and 136a are also coupled to signal scaling and conditioning modules 130a and 132a, respectively, by connections 12a and 13a, respectively. Connections 12a and 13a carry analog data received from the probe (not shown) that is placed on one or more parts of a machine (not shown). Such a machine may be a vehicle (e.g., a car), or any other machine that is to be tested. For example, a vehicle engine may be tested for parameters such as vibrations, emissions, engine speed, acceleration, or other parameters, using the probe that is placed on a portion of the vehicle's engine. Such parameters may be referred to as vehicle data herein. The probe then provides analog signals to connectors 134a and 136a corresponding to the parameter(s) under consideration. Signal scaling and conditioning modules 130a and 132a may be coupled to each other by a connection 17a. Signal scaling and conditioning modules 130a and 132a may be both coupled to an analog to digital converter (ADC) 126a by connections 14a and 15a, respectively. ADC 126a maybe coupled to FPGA 104a by a connection 5a. FPGA 104a may be coupled to a digital to analog converter (DAC) 128a by a connection 6a. DAC 128a may be further coupled to signal scaling and conditioning module 132a by a connection 16a. FPGA 104a may be coupled to a synchronous memory device 124a by a connection 4a.

It is to be noted that in one embodiment, internal components of measurement device 101a may have a different arrangement and design. By way of example only and not by way of limitation, measurement device 101a may be similar to a vehicle measurement apparatus shown in FIG. 2 of the above-referenced U.S. Patent Application Serial No. 13/801,346, entitled "VEHICLE MEASUREMENT APPARATUS HAVING A SYSTEM-ON-A-CHIP DEVICE AND A SENSOR," filed March 13, 2013. Further, wireless adapter system 100a may include other types of measurement devices couplable to wireless adapter 138a, as may be contemplated by one of ordinary skill in the art, and the description herein of measurement device 101a is by way of example only, and not by way of limitation. For example, in one embodiment, measurement device 101a may be an electronic multi-meter or an electronic scan tool coupled to wireless adapter 138a. As such, without the wireless adapter 138a, the measurement device 101a needs a wired connection to an external computing device to transfer or transmit the measured machine data. Such a cable or wired connection makes measurement device 101a and its operation unwieldy and cumbersome.

In one embodiment, wireless adapter 138a is a device that is couplable to measurement device 101a. Wireless adapter 138a forms an interface that transmits data wirelessly between measurement device 101a and the external computing device. For example, measurement device 101a may be placed upon an outside body of wireless adapter 138a. For example, the outside body of wireless adapter 138a is shaped or has a shape that can accommodate measurement device 101a. Such accommodation may be in the form of measurement device 101a docking to wireless adapter 138a. For example, the outside body of wireless adapter 138a may have a receptacle to latch measurement device 101a. The outside body of wireless adapter 138a may be made of a soft material to cradle measurement device 101a. Alternatively, the outside body of measurement device 101a may be shaped or has a shape that can accommodate wireless adapter 138a, for example, via a receptacle. In one embodiment, wireless adapter 138a is couplable to measurement device 101a at USB port 112a. For example, wireless adapter 138a may be inserted as a peripheral device to measurement device 101a at USB port 112a. Wireless adapter 138a may have one or more display devices on an outside body thereof. For example, a light emitting diode (LED), or a 7-segment display (both not shown) may indicate to a user of wireless adapter 138a a charge status of a batta therein, or operating conditions such as transmission and reception. Additionally, wireless adapter 138a may include one or more switches on the outside for switching wireless adapter 138a on and off.

In one embodiment, wireless adapter 138a includes a circuit board 139a having battery 140, a power supply and battery management unit 142a, a wireless module 144a, a USB host port 146a, a microprocessor 148a, and a USB device port 150a. For example, circuit board 139a may be a printed circuit board (PCB). Battery 140a may be coupled to power supply and battery management unit 142a by a connection 18a on circuit board 139a. Power supply and battery management unit 142a may be coupled to microprocessor 148a by a connection 19 on circuit board 139a. Wireless module 144a may be coupled to microprocessor 148a by a connection 20a on circuit board 139a. USB host port 146a may be coupled to microprocessor 148a by a connection 22a on circuit board 139a while USB device port 150a maybe coupled to microprocessor 148a by a connection 23a on circuit board 139a. USB device port 150a is coupled to USB host port 146a by a connection 21a on circuit board 139a.

In one embodiment, battery 140a is chargeable through USB device port 150a over connection 21a via connection 18a. For example, battery 140a is chargeable at a rate of up to 1.5A through USB device port 150a, in accordance with "USB Battery Charging 1.2 Compliance plan" by USB Implementers Forum Inc., dated October 12, 2011. In one embodiment, battery 140a supplies power to wireless adapter 138a internally. In one embodiment, battery 140a can supply power to measurement device 101a through USB host port 146a. For example, when measurement device 101a is used as a mobile or portable device, or when the mains supply power is not available to measurement device 101a, battery 140a can provide power to measurement device 101a. In one embodiment, battery 140a may be couplable to one or more external batteries that may be attached to the outside body of wireless adapter 138a. Such external batteries may increase the charge providing capability of battery 140a, and thus, of wireless adapter 138a to power itself and/or measurement device 101a. By way of example only, battery 140a may be a Lithium ion battery or a Lithium polymer type battery, although other types of batteries known to one of ordinary skill in the art may be used (e.g., Nickel-Cadmium battery).

In another embodiment, power supply and battery management unit 142a is configured to control power supplied to wireless adapter 138a. In one embodiment, power supply and battery management unit 142a may be configured to manage charging current received from USB device port 150a to charge battery 140a. Such a charging current may be received from an external computing device (e.g., a personal computer) coupled at USB device port 150a over connection 21a. In one embodiment, power supply and battery management unit 142a manages power supply from battery 140a and/or an external power source to measurement device 101a via USB host port 146a using microprocessor 148a, or directly (not shown). Power supply and battery management unit 142a may receive instructions to intelligently manage power distribution in circuit board 139a from an external computing device via USB device port 150a or from microprocessor 148a, or both. Power supply and battery management unit 142a may include one or more switches to electronically toggle between power from an external computing device, battery 140a, and a mains power supply.

In still another embodiment, wireless module 144a includes circuitry and antenna to implement wireless communication with an external computing device (not shown). By way of example only, wireless module 144a may be a Bluetooth wireless communication protocol device, a WiFi™ wireless communication protocol device, a near field communication device, or other wireless communication device known to one of ordinary skill in the art. An advantage of using the Bluetooth protocol is that it is simpler to implement and has lower power requirements as compared to WiFi® protocol. However, as known to one of ordinary skill in the art, WiFi® protocol is more secure. Wireless module 144a may receive measured vehicle data (e.g., automotive data), after processing by microprocessor 148a, from measurement device 101a via USB host port 146a coupled to USB port 112a of measurement device 101a. Wireless module 144a then initiates and maintains a transmission 24a to wirelessly transmit the processed data to an external computing device (e.g., a personal computer). By way of example only, wireless module 144a may be implemented using RN-42® or RN-230® wireless modules provided by Roving Networks, Inc. of Los Gatos, CA, although other types of wireless modules from other manufacturers could be used.

In one embodiment, microprocessor 148a is configured to execute computer executable instructions residing in a non-transitory memory (not shown) of wireless adapter 138a. When executed, the computer executable instructions cause microprocessor 148a to carry out various features and functionalities of the embodiments discussed herein. For example, microprocessor 148a may carry out one or more operations of a method 200a discussed in FIG. 2. Microprocessor 148a is interchangeably referred to herein as microprocessor 148a. In one embodiment, microprocessor 148a is configured to process the received data from measurement device 101a. The processed data may be sent to wireless module 144a over connection 20a for wireless transmission. In one embodiment, microprocessor 148a may transmit the processed data over a USB cable (not shown) attached to USB device port 150a. The USB cable may further couple to an external computing device. Such wired communication from microprocessor 148a may occur in addition to or as an alternative to wireless communication of processed data by wireless module 144a. By way of example only, microprocessor 148a may be an R5F10JBCAFP® processor provided by Renesas Electronics Corporation of Santa Clara, CA, although other types of processors from other manufacturers could be used.

In one embodiment, USB host port 146 couples to USB port 112a of measurement device 101 and USB host port 146a may provide power to measurement device 101a. Such power may be received from battery 140a, an external computing device, a mains power supply, or combinations thereof. For example, one or more pins/connection points of USB host port 146a may provide an electrical signal to corresponding one or more pins/connection points of USB port 112a to power measurement device 101a. In one embodiment, in addition to power transfer signals, USB host port 146a may receive data from measurement device 101a. Similarly, USB host port 146a may transmit data to measurement device 101a, for example, control signals, etc., from microprocessor 148a, the external computing device, or both.

Likewise, in one embodiment, USB device port 150a couples to one or more external computing devices. In one embodiment, USB device port 150a may receive an electrical current to charge battery 140a from the external computing device. Additionally or alternatively, USB device port 150a may receive updates or other instructions from the external computing device for wireless adapter 138a, measurement device 101a, or both. Further, USB device port 150a may transmit various data related to functioning of wireless adapter 138a, measurement device 101a, or both to the external computing device, for example, for debugging. In one embodiment, USB device port 150a may be optional, e.g., when wireless adapter 138a receives power from a power supply.

In one embodiment, connections 18a-23a are traces on circuit board 139a. Bi-directional arrows are used to indicate full-duplex communications or signal flows. Unidirectional arrows indicate simplex communications or signal flows. It is to be noted that circuit board 139a may have other additional connections, not shown, depending on additional components placed thereupon.

In addition to the components listed above, wireless adapter 138a and/or wireless adapter system 100a may have other electronic or mechanical components such as heat sinks, insulation, screws, latches, etc. Further, wireless adapter 138a and/or wireless adapter system 100a may have other serial and parallel interface, including but not limited to Universal Asynchronous Receiver/Transmitter (UART), Common System Interface (CSI), Inter-Integrated Circuit (I2C) buses, an interface to connect to an on-board diagnostics port (e.g., an OBD II port) of a vehicle, etc., known to those of ordinary skill in the art. In one embodiment, a power inlet may provide mains power to wireless adapter 138a and/or wireless adapter system 100a. For example, such a power inlet may be located at an outside surface of the body of wireless adapter 138a with an interface coupling to circuit board 139a for scaling and/or conditioning the supplied power to values suitable for wireless adapter 138a. The power inlet may operate in conjunction with or independent of battery 140a to power wireless adapter 138a, measurement device 101a, or both.

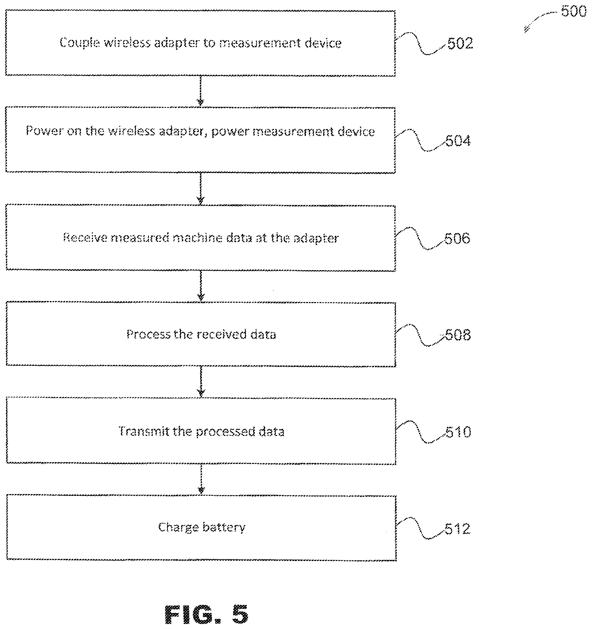

Referring to FIG. 5, method 500 for wirelessly transmitting machine data (e.g., vehicle data) using wireless adapter 138a is illustrated as a flowchart, in accordance with an embodiment. It is to be noted that although the operations shown in the flowchart of method 500 are in an increasing order, such operations are not restricted to any particular order. For example, the operations can be carried out independently, may be combined as a single operation, or may be optional under certain conditions, as will be apparent to one of ordinary skill in the art in view of the present disclosure.

In one embodiment, method 500 may begin in an operation 502. In operation 502, wireless adapter 138a is coupled to measurement device 101a. Coupling of wireless adapter 138a to measurement device 101a may occur by placing power measurement device 101a in a receptacle on an outside body of wireless adapter 138a. For example, such a receptacle on the outside surface of the body of wireless adapter 138a may be shaped to accommodate measuring device 101a. Alternatively, coupling may occur by placing wireless adapter 138a to a receptacle on the outside surface of the body of measurement device 101a. Coupling between wireless adapter 138a and measurement device 101a may occur by a direct connection between USB host port 146a and USB port 112a of wireless adapter 138a and measurement device 101a, respectively. For example, USB host port 146a and USB port 112a may be a male-female type pair of USB ports to connect wireless adapter 138a with measurement device 101a.

In one embodiment, in an operation 504, wireless adapter 138a is powered on. Powering wireless adapter 138a to turn on includes providing power internally to wireless adapter 138a using battery 140a. In one embodiment, powering wireless adapter 138a may occur by connecting wireless adapter 138a to a power supply, e.g., a mains power supply. For example, a switch on an outside body of wireless adapter 138a may be flipped on to power wireless adapter 138a. In one embodiment, powering wireless adapter 138a may occur by wireless adapter 138a receiving power from USB device port 150a connected to a power source (not shown). In one embodiment, the power source may be an external computing device or a power source of the external computing device. In one embodiment, microprocessor 148a may send signals to power supply and battery management unit 142a to intelligently switch between various powering schemes for wireless adapter 138a. In one embodiment, powering wireless adapter 138a may include powering measurement device 101a through wireless adapter 138a. For example, power from wireless adapter 138a (e.g., from battery 140a) may be provided to measurement device 101a over USB host port 146a. Likewise, when wireless adapter 138a is being powered by an external source, e.g., an external computing device, wireless adapter 138a may direct some of the power received from the external source to power measurement device 101a via USB host port 146a. For example, power supply and battery management unit 142a may be used to direct a portion of the received power (e.g., from battery 140a and/or the external power source) to measurement device 101a to obtain vehicle data therefrom. In one embodiment, such power provided to measurement device 101a via wireless adapter 138a maybe used before, during, or after measurement device 101a has provided vehicle data to wireless adapter 138a.

In one embodiment, in an operation 506, wireless adapter 138a receives measured machine data (e.g., vehicle data) from measurement device 101a. Measured machine data from measurement device 101a may be obtained at USB host port 146a of wireless adapter 138a. For example, such received data may be in digitized packet format after being processed by microprocessor 102a. Data received from measurement device 101a is forwarded to microprocessor 148a over connection 22a. In one embodiment, such receiving of data from measurement device 101a may occur in real-time, as measurements of machine parameters are being made by measurement device 101a. Alternatively, such receiving may occur offline after measurement device 101a has measured machine parameters to provide the measured machine parameters to wireless adapter 138a.

In one embodiment, in an operation 508, received machine data at wireless adapter 138a is processed at microprocessor 148a. Such processing includes modifying digital packets of measured data into a format suitable for wireless transmission by wireless module 144a. Other operations such as data integrity, encryption, redundancy, etc. may be performed on the received data by microprocessor 148a as part of the processing. For example, the processing may include converting the received digital packets of machine data to a format suitable for wired transmission from USB device port 150a to an external computing system. In one embodiment, processing of received data by microprocessor 148a includes executing computer executable code residing in a memory (e.g., an internal memory of microprocessor 148a) to process the received data.

In one embodiment, in an operation 510, processed data is transmitted wirelessly by wireless module 144a over transmission 24a. As discussed herein, such wireless transmission may occur using the Bluetooth or the WiFi® protocol, although other types of wireless protocols may be used. In one embodiment, such transmitting may be carried out over a wired channel (e.g., a USB cable) attached to USB device port 150a. In one embodiment, wireless adapter 138a may carry out such transmitting both wirelessly and over a wired channel for redundancy, or for transmitting to multiple external computing devices (e.g., PCs, mobile phones, etc.). In one embodiment, transmitting the processed data by wireless adapter 138a over a wired channel is independent of wireless transmission 24a.

In one embodiment, in an operation 512, battery 140a maybe charged. Charging may occur using the external computing device through USB device port 150a. For example, USB device port 150a may transfer a charging current of up to 1.5A from the external computing device over connection 21a to power supply and battery management unit 142a. Power supply and battery management unit 142a may provide the charging current to battery 140a over connection 18a. In one embodiment, charging battery 140a may occur over USB host port 146a. USB host port 146a may receive charging current from measurement device 101a. For example, measurement device 101a maybe coupled to a direct mains power supply, and may charge battery 140a. In one embodiment, battery 140a may be charged from a plurality of sources, or a combination of different power sources connecting at USB host port 146a, USB device port 150a, or both.

By way of example only, advantageously, various embodiments discussed herein eliminate the need for having a wired connection between measurement device 101a and an external computing system where measured data from measurement device 101a may be processed or analyzed. For example, measurement device 101a may be an oscilloscope with a probe under a hood of a car. By coupling wireless adapter 138a to such an oscilloscope, a user located away from and outside the hood of the car may wirelessly receive measured machine data (e.g., engine speed, acceleration, vibration, etc.) at a laptop or other computer. Further, using battery 140a, for example, wireless adapter 138a may power the oscilloscope, eliminating the need for other wires to power the oscilloscope. Various embodiments of the disclosure discussed herein enable wireless adapter system 100a to free a user from worrying about placing wires from measurement device 101a in a corrosive environment (e.g., a hot machine part) that may damage the wires. Additionally, multiple recipients can obtain measured data wirelessly from wireless adapter 138a for analysis or parallel processing thereat.

## Claims

1. A wireless adapter (138a) for a measurement device (101a), comprising:
a first universal serial bus (USB) host port (146a) to couplably receive vehicle data from the measurement device (101a);
a battery (140a) that powers the measurement device (101a) via the first USB host port (146a);
a wireless module (144a) to wirelessly transmit the received vehicle data to an external computing device after processing by the wireless adapter (138a);
a processor (148) coupled to the first USB host port (146a), the processor (148a) processing the received vehicle data; and
a power supply and management unit (142a) coupled to the first USB host port (146a),
wherein the battery (140a) and an external power source are coupled to the power supply and management unit (142a) to power the wireless adapter (138a) and send a portion of the power from the external power source to the measurement device (101a) to obtain data.

2. The wireless adapter (138a) of claim 1, wherein the battery (140a) is a Lithium ion or a Lithium polymer type battery.

3. The wireless adapter (138a) of claim 1 further comprising:
a second USB port (150a) coupled to the processor (148a) to communicate with the external computing device over a USB cable.

4. The wireless adapter (138a) of claim 3, wherein the battery (104a) inside the wireless adapter (138a) is chargeable through the second USB port (150a).

5. The wireless adapter (138a) of claim 1, wherein an outside body of the wireless adapter (138a) is configured to have the measurement device (101a) placed thereupon.

6. The wireless adapter (138a) of claim 1, wherein the wireless module (144a) is a Bluetooth or a WiFi protocol device.

7. The wireless adapter (138a) of claim 1, wherein the first USB host port (146a) couples to a USB port (112a) of the measurement device (101a) to receive the data.

8. The wireless adapter (138a) of claim 1, wherein at least a part of an outside body of the wireless adapter (138a) is made of a soft material to cradle the measurement device (101a).

9. A method for wirelessly transmitting vehicle data, comprising:
receiving (506), at a first universal serial bus (USB) host port (146a) of a wireless adapter (138a) coupled to a measurement device (101a), the vehicle data from the measurement device (101a);
processing (508), at a processor (148) of the wireless adapter (138a), the received vehicle data;
transmitting wirelessly (510), from a wireless module (144a) of the wireless adapter (138a), the processed vehicle data to an external computing device; and
powering the measurement device (101a), with a power supply and management unit (142a) of the wireless adapter (138a), the power supply and management unit (138a) being coupled to the first USB host port (146a), and receives power from a battery (140a) and an external power supply, wherein powering includes sending a portion of the power from the external power supply to the measurement device (101a) to obtain the received data.

10. The method of claim 9, wherein the powering using the battery (140a) is carried out internal to the wireless adapter (138a).

11. The method of claim 9, wherein powering is carried out through a second universal serial bus (USB) port (150a) to provide (512) a charge to the battery.

12. The method of claim 9, wherein the powering the measurement device (101a) is carried out during the receiving of the vehicle data.

13. The method of claim 9, wherein the transmitting comprises:
transmitting the processed received vehicle data using a Bluetooth or a WiFi protocol of a wireless module (144a) in the wireless adapter (138a).

14. The method of claim 9 further comprising:
placing the measurement device (101a) in a receptacle on an outside body of the wireless adapter (138a) to perform the powering.

15. The method of claim 9 further comprising:
transmitting the processed received vehicle data over a wired channel independent of the wirelessly transmitted processed received vehicle data.

16. The wireless adapter (138a) of claim 1, wherein the power supply and management unit (142a) is further configured send a portion of the power from the battery (140a) and the external power source to the measurement device (101a) to obtain data.

## Patentansprüche

1. Drahtloser Adapter (138a) für eine Messvorrichtung (101a), umfassend:
einen ersten Hostanschluss mit einem universellen seriellen Bus (USB-Hostanschluss) (146a), der anschließbar Fahrzeugdaten von der Messvorrichtung (101a) empfängt;
eine Batterie (140a), welche die Messvorrichtung (101a) über den ersten USB-Hostanschluss (146a) mit Strom versorgt;
ein drahtloses Modul (144a) zum drahtlosen Übertragen der empfangenen Fahrzeugdaten an eine externe Computervorrichtung nach einer Verarbeitung durch den drahtlosen Adapter (138a);
einen Prozessor (148), der mit dem ersten USB-Hostanschluss (146a) verbunden ist, wobei der Prozessor (148a) die empfangenen Fahrzeugdaten verarbeitet; und
eine Stromversorgungs- und Verwaltungseinheit (142a), die mit dem ersten USB-Hostanschluss (146a) verbunden ist,
wobei die Batterie (140a) und eine externe Stromquelle mit der Stromversorgungs- und Verwaltungseinheit (142a) verbunden sind, um den drahtlosen Adapter (138a) mit Strom zu versorgen und um einen Teil des Stroms von der externen Stromquelle an die Messvorrichtung (101a) zu senden, um die Daten zu erhalten.

2. Drahtloser Adapter (138a) nach Anspruch 1, wobei die Batterie (140a) eine Batterie vom Typ Lithium-Ionen- oder Lithium-Polymer-Batterie ist.

3. Drahtloser Adapter (138a) nach Anspruch 1, der außerdem umfasst:
einen zweiten USB-Anschluss (150a), der mit dem Prozessor (148a) verbunden ist, um über ein USB-Kabel mit der externen Computervorrichtung zu kommunizieren.

4. Drahtloser Adapter (138a) nach Anspruch 3, wobei die Batterie (104a) innerhalb des drahtlosen Adapters (138a) durch den zweiten USB-Anschluss (150a) aufladbar ist.

5. Drahtloser Adapter (138a) nach Anspruch 1, wobei eine Außenseite des drahtlosen Adapters (138a) konfiguriert ist, um die Messvorrichtung (101a) auf derselben anzubringen.

6. Drahtloser Adapter (138a) nach Anspruch 1, wobei das drahtlose Modul (144a) eine Bluetooth- oder eine Wi-Fi-Protokollvorrichtung ist.

7. Drahtloser Adapter (138a) nach Anspruch 1, wobei der erste USB-Hostanschluss (146a) mit einem USB-Anschluss (112a) der Messvorrichtung (101a) verbunden ist, um die Daten zu empfangen.

8. Drahtloser Adapter (138a) nach Anspruch 1, wobei mindestens ein Teil der Außenseite des drahtlosen Adapters (138a) aus einem weichen Material hergestellt ist, um die Messvorrichtung (101a) zu halten.

9. Verfahren zum drahtlosen Übertragen von Fahrzeugdaten, umfassend:
Empfangen (506) von Fahrzeugdaten von einer Messvorrichtung (101a) in einem ersten Hostanschluss mit einem universellen seriellen Bus (USB-Hostanschluss) (146a) eines drahtlosen Adapters (138a), der mit der Messvorrichtung (101a) verbunden ist;
Verarbeiten (508) der empfangenen Fahrzeugdaten in einem Prozessor (148) des drahtlosen Adapters (138a);
drahtloses Übertragen (510) der verarbeiteten Fahrzeugdaten von einem drahtlosen Modul (144a) des drahtlosen Adapters (138a) an eine externe Computervorrichtung; und
Versorgen der Messvorrichtung (101a) mit Strom durch eine Stromversorgungs- und Verwaltungseinheit (142a) des drahtlosen Adapters (138a), wobei die Stromversorgungs- und Verwaltungseinheit (138a) mit dem ersten USB-Hostanschluss (146a) verbunden ist und Strom von einer Batterie (140a) und einer externen Stromversorgung empfängt, wobei das Versorgen mit Strom ein Senden eines Teils des Stroms von der externen Stromversorgung an die Messvorrichtung (101a) umfasst, um die empfangenen Daten zu erhalten.

10. Verfahren nach Anspruch 9, wobei das Versorgen mit Strom mithilfe der Batterie (140a) innerhalb des drahtlosen Adapters (138a) ausgeführt wird.

11. Verfahren nach Anspruch 9, wobei das Versorgen mit Strom durch einen zweiten universellen seriellen Busanschluss (USB-Anschluss) (150a) ausgeführt wird, um der Batterie eine Ladung bereitzustellen (512).

12. Verfahren nach Anspruch 9, wobei das Versorgen mit Strom der Messvorrichtung (101a) während des Empfangens der Fahrzeugdaten ausgeführt wird.

13. Verfahren nach Anspruch 9, wobei das Übertragen umfasst:
Übertragen der verarbeiteten empfangenen Fahrzeugdaten mithilfe eines Bluetooth-Protokolls oder einem Wi-Fi-Protokoll eines Drahtlosmoduls (144a) in dem drahtlosen Adapter (138a).

14. Verfahren nach Anspruch 9, das außerdem aufweist:
Anbringen der Messvorrichtung (101a) in einem Behältnis auf der Außenseite des drahtlosen Adapters (138a), um die Stromversorgung auszuführen.

15. Verfahren nach Anspruch 9, das außerdem aufweist:
Übertragen der verarbeiteten empfangenen Fahrzeugdaten über einen verkabelten Kanal unabhängig von den drahtlos übertragenen empfangenen Fahrzeugdaten.

16. Drahtloser Adapter (138a) nach Anspruch 1, wobei die Stromversorgungs- und Verwaltungseinheit (142a) außerdem konfiguriert ist, um einen Teil des Stroms von der Batterie (140a) und der externen Stromquelle an die Messvorrichtung (101a) zu senden, um die Daten zu erhalten.

## Revendications

1. Adaptateur sans fil (138a) pour un dispositif de mesure (101a), comprenant :
un premier port hôte sur bus série universel (USB) (146a) pour recevoir par couplage des données de véhicule en provenance du dispositif de mesure (101a) ;
une batterie (140a) qui alimente le dispositif de mesure (101a) par l'intermédiaire du premier port hôte USB (146a) ;
un module sans fil (144a) pour transmettre sans fil les données de véhicule reçues à un dispositif informatique externe après le traitement par l'adaptateur sans fil (138a) ;
un processeur (148) couplé au premier port hôte USB (146a), le processeur (148a) traitant les données de véhicule reçues ; et
une unité d'alimentation et de gestion (142a) couplé au premier port hôte USB (146a),
la batterie (140a) et une source électrique externe étant couplées à l'unité d'alimentation et de gestion (142a) pour alimenter l'adaptateur sans fil (138a) et envoyer une partie du courant électrique de la source électrique externe au dispositif de mesure (101a) afin d'obtenir des données.

2. Adaptateur sans fil (138a) selon la revendication 1, dans lequel la batterie (140a) est une batterie de type lithium-ion ou lithium-polymère.

3. Adaptateur sans fil (138a) selon la revendication 1, comprenant en outre :
un second port USB (150a) couplé au processeur (148a) pour communiquer avec le dispositif informatique externe sur un câble USB.

4. Adaptateur sans fil (138a) selon la revendication 3, dans lequel la batterie (104a) à l'intérieur de l'adaptateur sans fil (138a) peut être chargée par l'intermédiaire du second port USB (150a).

5. Adaptateur sans fil (138a) selon la revendication 1, dans lequel un corps extérieur de l'adaptateur sans fil (138a) est configuré pour que le dispositif de mesure (101a) y soit placé dessus.

6. Adaptateur sans fil (138a) selon la revendication 1, dans lequel le module sans fil (144a) est un dispositif sur protocole Bluetooth ou Wi-Fi.

7. Adaptateur sans fil (138a) selon la revendication 1, dans lequel le premier port hôte USB (146a) se couple à un port USB (112a) du dispositif de mesure (101a) pour recevoir les données.

8. Adaptateur sans fil (138a) selon la revendication 1, dans lequel au moins une partie d'un corps extérieur de l'adaptateur sans fil (138a) est constituée d'un matériau souple pour supporter le dispositif de mesure (101a).

9. Procédé de transmission sans fil de données de véhicule, consistant à :
recevoir (506), au niveau d'un premier port hôte sur bus série universel (USB) (146a) d'un adaptateur sans fil (138a) couplé à un dispositif de mesure (101a), les données de véhicule en provenance du dispositif de mesure (101a) ;
traiter (508), au niveau d'un processeur (148) de l'adaptateur sans fil (138a), les données de véhicule reçues ;
transmettre sans fil (510), à partir d'un module sans fil (144a) de l'adaptateur sans fil (138a), les données de véhicule traitées à un dispositif informatique externe ; et
alimenter le dispositif de mesure (101a), avec une unité d'alimentation et de gestion (142a) de l'adaptateur sans fil (138a), l'unité d'alimentation et de gestion (138a) étant couplée au premier port hôte USB (146a) et recevant un courant électrique d'une batterie (140a) et d'une alimentation externe, l'alimentation consistant à envoyer une partie du courant électrique de l'alimentation externe au dispositif de mesure (101a) afin d'obtenir les données reçues.

10. Procédé selon la revendication 9, dans lequel l'alimentation au moyen de la batterie (140a) est réalisée à l'intérieur de l'adaptateur sans fil (138a).

11. Procédé selon la revendication 9, dans lequel l'alimentation est réalisée par l'intermédiaire d'un second port sur bus série universel (USB) (150a) pour fournir (512) une charge à la batterie.

12. Procédé selon la revendication 9, dans lequel l'alimentation du dispositif de mesure (101a) est réalisée pendant la réception des données de véhicule.

13. Procédé selon la revendication 9, dans lequel la transmission comprend :
transmettre les données de véhicule reçues et traitées au moyen d'un protocole Bluetooth ou Wi-Fi d'un module sans fil (144a) dans l'adaptateur sans fil (138a).

14. Procédé selon la revendication 9, consistant en outre à :
placer le dispositif de mesure (101a) dans un réceptacle sur un corps extérieur de l'adaptateur sans fil (138a) pour réaliser l'alimentation.

15. Procédé selon la revendication 9, consistant en outre à :
transmettre les données de véhicule reçues et traitées sur un canal câblé indépendamment des données de véhicule reçues, traitées et transmises sans fil.

16. Adaptateur sans fil (138a) selon la revendication 1, dans lequel l'unité d'alimentation et de gestion (142a) est en outre configurée pour envoyer une partie du courant électrique de la batterie (140a) et de la source électrique externe au dispositif de mesure (101a) afin d'obtenir des données.
